# EUROPEAN PATENT APPLICATION

(11) **EP 4 254 466 A1**
(43) Date of publication of application: **04.10.2023**
(21) Application number: 21897989.6
(22) Date of filing: 24.11.2021
(51) Int. Cl.: H01J 37/147, H01L 21/027

(54) **METHOD FOR MANUFACTURING ELECTROSTATIC DEFLECTOR, AND ELECTROSTATIC DEFLECTOR**

(30) Priority: 30.11.2020 JP 2020199235
(71) Applicant: Kyocera Corporation, Kyoto-shi Kyoto 612-8501 (JP)
(72) Inventor: MUNEISHI, Takeshi, Kyoto-shi, Kyoto 612-8501 (JP)
(74) Representative: Viering, Jentschura & Partner mbB Patent- und Rechtsanwälte
(86) International application number: PCT/JP2021/043033
(87) International publication number: WO 2022/114017

(57) **Abstract**

The manufacturing method for an electrostatic deflector includes: obtaining a plurality of first compacts (10) having a sheet-like shape by molding a raw material containing a ceramic into each desired shape; obtaining a second compact (30) by layering the plurality of first compacts (10); obtaining a tubular body (110) by firing the second compact (30); and forming an internal electrode (120) and an external electrode (130) on an inner wall surface (111) of the tubular body (110) and on a surface other than the inner wall surface (111). In the obtaining the plurality of first compacts (10), a wiring layer (21) serving as a connection conductor (140) that electrically connects the internal electrode (120) and the external electrode (130) is formed on a surface of the first compact (10) that is predetermined.

## Description

### TECHNICAL FIELD

The disclosed embodiment relates to a manufacturing method for an electrostatic deflector and an electrostatic deflector.

### BACKGROUND OF INVENTION

In the related art, an electrostatic deflector mounted on an electron beam exposure device or an electron beam irradiation device uses a cylindrical base made of a ceramic sintered body in order to deflect the trajectory of an electron beam. Generally, a plurality of polarized internal electrodes are provided at intervals on an inner wall surface of the cylindrical base, and a voltage is applied to each of these internal electrodes to generate a magnetic field, thereby controlling the irradiation direction of the electron beam (see Paten Document 1, for example).

### CITATION LIST

### PATENT LITERATURE

Patent Document 1: JP 2005-190853 A

### SUMMARY

In one aspect of the embodiment, an object is to provide a manufacturing method for an electrostatic deflector and an electrostatic deflector capable of reducing the number of components.

### SOLUTION TO PROBLEM

A method of manufacturing an electrostatic deflector according to an aspect of an embodiment includes: obtaining a plurality of first compacts having a sheet-like shape by molding a raw material containing a ceramic into each desired shape; obtaining a second compact by layering the plurality of first compacts; obtaining a tubular body by firing the second compact; and forming an internal electrode and an external electrode on an inner wall surface of the tubular body and on a surface other than the inner wall surface. In the obtaining the plurality of first compacts, a wiring layer serving as a connection conductor that electrically connects the internal electrode and the external electrode is formed on a surface of the first compact that is predetermined.

### BRIEF DESCRIPTION OF THE DRAWINGS

FIG. 1 is a top view and a cross-sectional view illustrating an example of a configuration of a first compact according to the embodiment.
FIG. 2 is a top view and a cross-sectional view illustrating an example of the configuration of the first compact according to the embodiment.
FIG. 3 is a top view and a cross-sectional view illustrating an example of the configuration of the first compact according to the embodiment.
FIG. 4 is a top view and a cross-sectional view illustrating an example of the configuration of the first compact according to the embodiment.
FIG. 5 is a top view and a cross-sectional view illustrating an example of the configuration of the first compact according to the embodiment.
FIG. 6 is a perspective view illustrating an example of a configuration of a second compact according to the embodiment.
FIG. 7 is a cross-sectional view taken along a line A-A in a direction of arrows illustrated in FIG. 6.
FIG. 8 is a cross-sectional view taken along a line B-B in a direction of arrows illustrated in FIG. 6.
FIG. 9 is a cross-sectional view taken along a line C-C in a direction of arrows illustrated in FIG. 6.
FIG. 10 is a top view illustrating a configuration of an electrostatic deflector according to the embodiment.
FIG. 11 is a cross-sectional view taken along a line D-D in a direction of arrows illustrated in FIG. 10.
FIG. 12 is a horizontal cross-sectional view illustrating a configuration of the electrostatic deflector according to the embodiment.
FIG. 13 is a cross-sectional view taken along a line E-E in a direction of arrows illustrated in FIG. 10.
FIG. 14 is a horizontal cross-sectional view illustrating a configuration of the electrostatic deflector according to the embodiment.
FIG. 15 is an enlarged cross-sectional view illustrating a configuration of a connection conductor according to the embodiment.
FIG. 16 is a vertical cross-sectional view illustrating a configuration of an electrostatic deflector according to a first variation of the embodiment.
FIG. 17 is a vertical cross-sectional view illustrating a configuration of an electrostatic deflector according to a second variation of the embodiment.
FIG. 18 is a vertical cross-sectional view illustrating a configuration of an electrostatic deflector according to a third variation of the embodiment.
FIG. 19 is a vertical cross-sectional view illustrating a configuration of an electrostatic deflector according to a fourth variation of the embodiment.
FIG. 20 is a vertical cross-sectional view illustrating a configuration of an electrostatic deflector according to a fifth variation of the embodiment.
FIG. 21 is a vertical cross-sectional view illustrating a configuration of an electrostatic deflector according to a sixth variation of the embodiment.
FIG. 22 is a top view illustrating a configuration of an electrostatic deflector according to a seventh variation of the embodiment.

### DESCRIPTION OF EMBODIMENTS

Hereinafter, embodiments of a manufacturing method for an electrostatic deflector and an electrostatic deflector disclosed in the present disclosure will be described with reference to the accompanying drawings. The present invention is not limited by the following embodiments. In each of the following embodiments, the same reference numerals are assigned to the same portions and redundant descriptions thereof will be omitted.

In the related art, an electrostatic deflector mounted on an electron beam exposure device or an electron beam irradiation device uses a cylindrical base made of a ceramic sintered body in order to deflect the trajectory of an electron beam. Generally, a plurality of polarized internal electrodes are provided at intervals on an inner wall surface of the cylindrical base, and a voltage is applied to each of these internal electrodes to generate a magnetic field, thereby controlling the irradiation direction of the electron beam.

However, in the related art, in order to apply a voltage to the internal electrodes formed on the inner wall surface of the cylindrical base, a conductive pin is inserted through each internal electrode from the outer wall surface side. Therefore, the number of components is increased by the number of internal electrodes, which could increase the manufacturing cost.

In particular, when disposing a ground electrode on the inner wall surface of the electrostatic deflector in addition to the internal electrodes, the number of components is further increased, which could significantly increase the manufacturing cost.

Therefore, it is expected to realize a manufacturing method for an electrostatic deflector and an electrostatic deflector capable of solving the above-described problems and reducing the number of components.

### First Molding Step

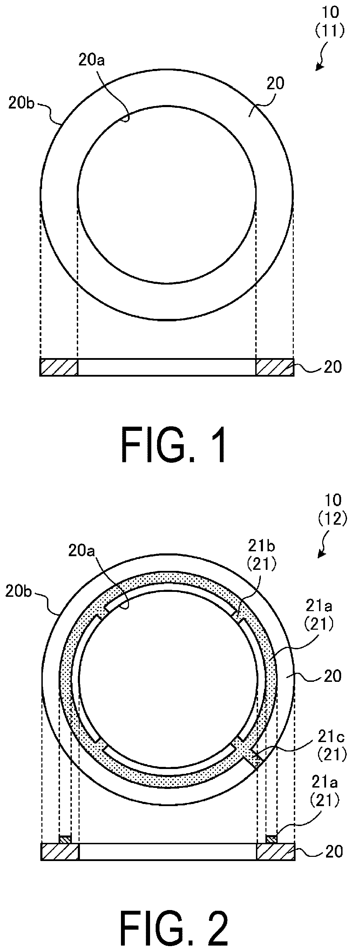

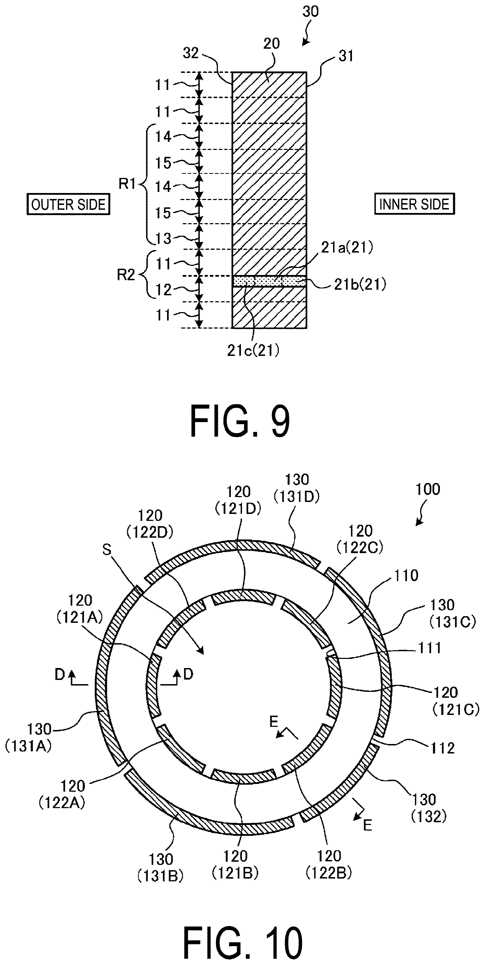

In a step of manufacturing an electrostatic deflector 100 (see FIG. 10) according to the embodiment, first, a step of molding a first compact 10 is performed. The configuration of the first compact 10 will be described with reference to FIGs. 1 to 5.

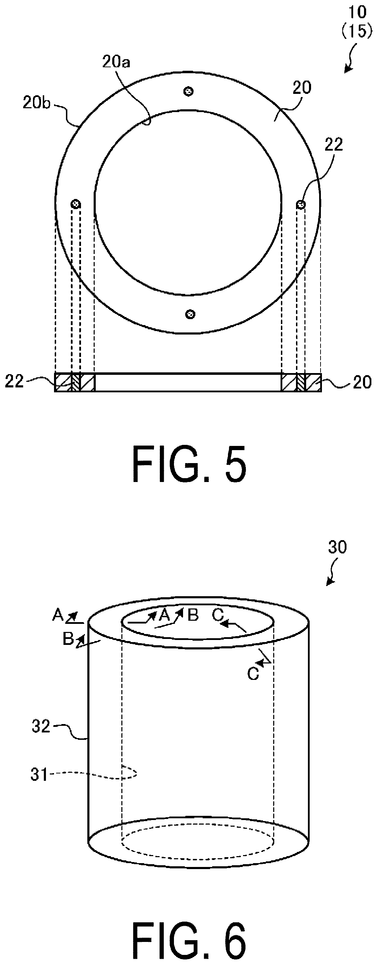

FIGs. 1 to 5 are top views and cross-sectional views illustrating examples of configurations of the first compact 10 according to the embodiment. Note that, in the present disclosure, a second compact 30 (see FIG. 6) is molded by combining five types of the first compacts 10, and thus the five types of the first compacts 10 are respectively referred to as first compacts 11 to 15. FIG. 1 illustrates the first compact 11 which is one of the five types of the first compacts 10.

As illustrated in FIG. 1, the first compact 11 includes a body portion 20 obtained by annularly molding a raw material containing a ceramic. The body portion 20 is molded in, for example, an annular shape. The thickness of the body portion 20 is about from 0.2 to 2 (mm), for example.

The body portion 20 contains, for example, aluminum oxide (Al₂O₃), yttrium oxide (Y₂O₃), zirconium oxide (ZrO₂), cordierite, silicon nitride (Si₃N₄), aluminum nitride (AlN), mullite, or the like as a main component.

The body portion 20 may contain, for example, as a main component, aluminum oxide to which titanium oxide (TiO₂) is added as a conductive component for adjusting the volume resistivity.

FIG. 2 illustrates the first compact 12 which is one of the five types of the first compacts 10. The first compact 12 illustrated in FIG. 2 includes the body portion 20 obtained by annularly molding a raw material containing a ceramic. The body portion 20 of the first compact 12 is molded in, for example, an annular shape, and has an outer diameter, an inner diameter, and a thickness substantially equal to those of the body portion 20 of the first compact 11 illustrated in FIG. 1.

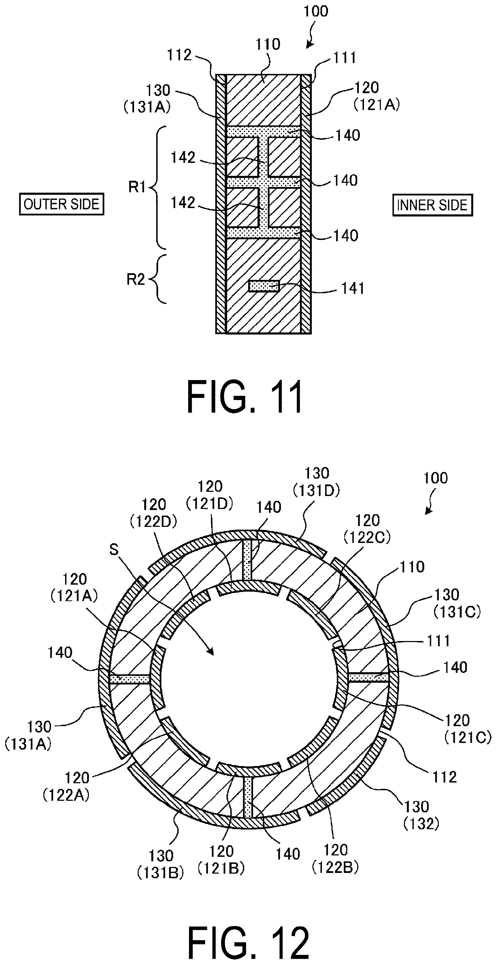

The first compact 12 includes a wiring layer 21 located on the upper surface of the body portion 20. The wiring layer 21 is made of a paste containing a metal such as gold, silver, copper, platinum, rhenium, nickel, tungsten, or molybdenum, and serves as connection conductors 140 and 141 (see FIG. 11) of the electrostatic deflector 100 after the second compact 30 (see FIG. 6) is fired.

The thickness of the wiring layer 21 is, for example, about from 0.1 to 20 (µm), and the width of the wiring layer 21 is, for example, about from 500 (µm) to 20 (mm).

The wiring layer 21 of the first compact 12 includes an annular portion 21a, an inner peripheral connecting portion 21b, and an outer peripheral connecting portion 21c. The annular portion 21a is formed in an annular shape along the peripheral direction of the body portion 20, and is located between an inner peripheral portion 20a and an outer peripheral portion 20b of the body portion 20.

The inner peripheral connecting portion 21b is a portion extending from the annular portion 21a toward the inner peripheral portion 20a of the body portion 20. A plurality of (four in the drawing) inner peripheral connecting portions 21b are disposed at positions corresponding to ground electrodes 122A to 122D (see FIG. 10) of the electrostatic deflector 100.

The outer peripheral connecting portion 21c is a portion extending from the annular portion 21a toward the outer peripheral portion 20b of the body portion 20. The outer peripheral connecting portion 21c is disposed at a position corresponding to an external ground electrode 132 (see FIG. 10) of the electrostatic deflector 100.

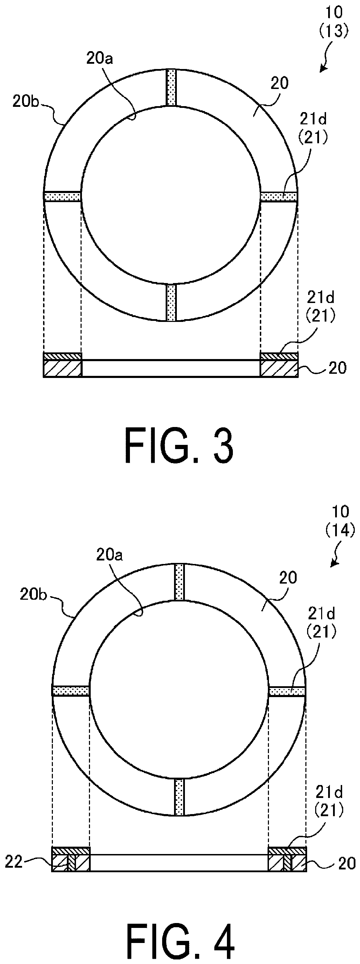

FIG. 3 illustrates the first compact 13 which is one of the five types of the first compacts 10. The first compact 13 illustrated in FIG. 3 includes the body portion 20 obtained by annularly molding a raw material containing a ceramic. The body portion 20 of the first compact 13 is molded in, for example, an annular shape, and has an outer diameter, an inner diameter, and a thickness substantially equal to those of the body portion 20 of the first compact 11 illustrated in FIG. 1.

The first compact 13 includes the wiring layer 21 located on the upper surface of the body portion 20. The wiring layer 21 of the first compact 13 includes a plurality of (four in the drawing) connecting portions 21d. The connecting portion 21d extends from the inner peripheral portion 20a toward the outer peripheral portion 20b of the body portion 20. The connecting portions 21d are disposed at positions corresponding to deflection electrodes 121A to 121D (see FIG. 10) of the electrostatic deflector 100.

FIG. 4 illustrates the first compact 14 which is one of the five types of the first compacts 10. The first compact 14 illustrated in FIG. 4 includes the body portion 20 obtained by annularly molding a raw material containing a ceramic. The body portion 20 of the first compact 14 is molded in, for example, an annular shape, and has an outer diameter, an inner diameter, and a thickness substantially equal to those of the body portion 20 of the first compact 11 illustrated in FIG. 1.

The first compact 14 includes the wiring layer 21 located on the upper surface of the body portion 20. The wiring layer 21 of the first compact 14 includes a plurality of (four in the drawing) connecting portions 21d. The connecting portion 21d extends from the inner peripheral portion 20a toward the outer peripheral portion 20b of the body portion 20. The connecting portions 21d are disposed at positions corresponding to deflection electrodes 121A to 121D (see FIG. 10) of the electrostatic deflector 100.

The first compact 14 includes a through wiring layer 22 passing through the inner portion of the body portion 20. The through wiring layer 22 is an example of another wiring layer. The through wiring layer 22 extends from a position in contact with the connecting portion 21d on the upper surface of the body portion 20 toward the lower surface of the body portion 20.

The through wiring layer 22 is made of a paste containing a metal such as gold, silver, copper, platinum, rhenium, nickel, tungsten, or molybdenum, and serves as a via conductor 142 (see FIG. 11) of the electrostatic deflector 100 after the second compact 30 (see FIG. 6) is fired. The maximum diameter of the through wiring layer 22 is, for example, about 50 (µm).

FIG. 5 illustrates the first compact 15 which is one of the five types of the first compacts 10. The first compact 15 illustrated in FIG. 5 includes the body portion 20 obtained by annularly molding a raw material containing a ceramic. The body portion 20 of the first compact 15 is molded in, for example, an annular shape, and has an outer diameter, an inner diameter, and a thickness substantially equal to those of the body portion 20 of the first compact 11 illustrated in FIG. 1.

The first compact 15 includes the through wiring layer 22 passing through the inner portion of the body portion 20. The through wiring layer 22 of the first compact 15 is disposed at the same position as the through wiring layer 22 of the first compact 14 in a plan view.

Next, an example of the first molding step of molding the first compact 10 described above will be described. First, predetermined amounts of a sintering aid, a binder, a solvent, a dispersant, and the like are added to a raw material powder such as aluminum oxide, followed by mixing, whereby slurry is prepared.

The prepared slurry is spray dried by a spray-granulation method (spray drying method) to be granulated and a green sheet is formed by a roll compaction method.

The green sheet obtained is processed using a known method such as a laser or a metal mold so as to have a desired annular shape to mold the body portion 20 of the first compact 10. A paste of platinum powder or the like is embedded in a predetermined green sheet to form the through wiring layer 22.

A paste of platinum powder or the like is screen-printed on a predetermined green sheet to form the wiring layer 21. Accordingly, the first molding step according to the embodiment is completed.

Note that, in the present disclosure, an example in which the green sheet is formed by the roll compaction method is described. However, a technique for forming the green sheet is not limited to the roll compaction method, and for example, a doctor blade method, an extrusion method, or the like may be used.

On the other hand, since the roll compaction method enables a thick green sheet to be formed relatively easily, the number of layers of the first compact 10 can be reduced in the subsequent second molding step. Thus, according to the embodiment, the manufacturing cost of the electrostatic deflector 100 can be reduced.

### Second Molding Step

In a step of manufacturing the electrostatic deflector 100 (see FIG. 10) according to the embodiment, a step of molding the second compact 30 is performed subsequent to the first molding step. The configuration of the second compact 30 will be described with reference to FIGs. 6 to 9.

FIG. 6 is a perspective view illustrating an example of the configuration of the second compact 30 according to the embodiment. As illustrated in FIG. 6, the second compact 30 has a tubular shape, for example, a cylindrical shape. The second compact 30 includes an inner wall surface 31 and an outer wall surface 32.

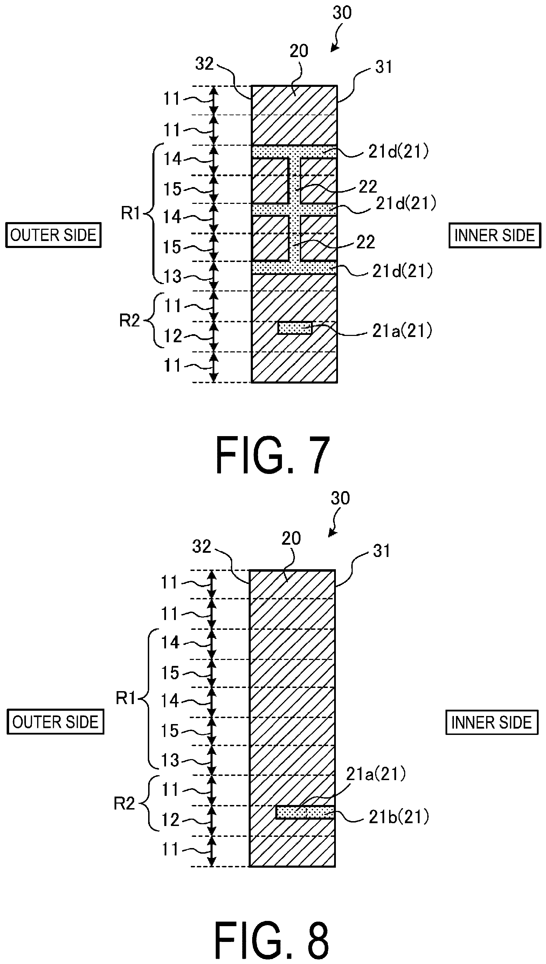

FIGs. 7 to 9 are cross-sectional views taken along the line A-A, line B-B, and line C-C in directions of arrows illustrated in FIG. 6. As illustrated in FIGs. 7 to 9, the second compact 30 is molded by layering the plurality of first compacts 11 to 15 (that is, the plurality of first compacts 10) in a predetermined order.

The second compact 30 includes a site constituted by the first compact 11 in which the wiring layer 21 and the through wiring layer 22 are not disposed, a first region R1, and a second region R2. The first region R1 includes the first compact 13 including the connecting portion 21d, the first compact 14 including the connecting portion 21d and the through wiring layer 22, and the first compact 15 including the through wiring layer 22.

As a result, in the first region R1, as illustrated in FIG. 7, a plurality of (three in the drawing) connecting portions 21d are disposed side by side, and adjacent connecting portions 21d are connected to each other via the through wiring layer 22.

The second region R2 includes the first compact 11 in which the wiring layer 21 and the through wiring layer 22 are not disposed and the first compact 12 including the annular portion 21a, the inner peripheral connecting portion 21b, and the outer peripheral connecting portion 21c.

Accordingly, in the second region R2, as illustrated in FIGs. 7 to 9, the annular portion 21a, the inner peripheral connecting portion 21b, and the outer peripheral connecting portion 21c are disposed to be separated from the other wiring layers 21 and the through wiring layer 22.

An example of the second molding step of molding the second compact 30 described above will be described. First, the first compacts 11 to 15 are layered in the order illustrated in FIGs. 7 to 9 by a layering method. The layered body is press molded at a predetermined molding pressure to be brought into close contact with each other. Accordingly, the second molding step according to the embodiment is completed.

Note that, in the present disclosure, an example in which the second compact 30 is molded using the first compacts 11 to 15 having substantially the same thickness is shown. However, the second compact 30 may be molded using the first compacts 11 to 15 with different thicknesses at least in part.

In the present disclosure, an example in which the second compact 30 is molded using five types of the first compacts 10 (the first compacts 11 to 15) is shown. However, the types of the first compacts 10 molding the second compacts 30 are not limited to five types.

In the present disclosure, the case where the annular first compacts 11 are layered to mold the tubular second compact 30 is shown. However, the present disclosure is not limited to such an example. For example, the plate-like first compacts 10 may be layered to form the columnar second compact 30, and a through hole may be formed in the columnar second compact 30 to form the tubular second compact 30.

### Firing Step, Grinding Step, and Electrode Forming Step

In the step of manufacturing the electrostatic deflector 100 according to the embodiment, the second molding step is followed by the firing step, the grinding step, and the electrode forming step.

The firing step is performed, for example, by raising the temperature to a predetermined firing temperature (for example, about 1300 to 1700°C when aluminum oxide is the main component) in an atmosphere suitable for the material of the second compact 30, and holding the temperature for a predetermined time (for example, about 3 hours) after the temperature is raised. The grinding step of grinding the surface of a tubular body 110 (see FIG. 10) obtained is performed by a known grinding method.

Note that, in the present disclosure, the case where the tubular body 110 is obtained by firing the tubular second compact 30 is shown. However, the present disclosure is not limited to such an example. For example, the tubular body 110 may be obtained by molding and firing the columnar second compact 30 and forming a through hole in the obtained columnar sintered body.

The electrostatic deflector 100 according to the embodiment is obtained through the electrode forming step of forming various electrodes on an inner wall surface 111 (see FIG. 10) and an outer wall surface 112 (see FIG. 10) of the ground tubular body 110. As the electrode forming step, for example, an electroless plating method or the like can be used.

Hereinafter, the configuration of the electrostatic deflector 100 obtained will be described with reference to FIGs. 10 to 15. FIG. 10 is a top view illustrating a configuration of the electrostatic deflector 100 according to the embodiment.

As illustrated in FIG. 10, the electrostatic deflector 100 includes the tubular body 110, a plurality of internal electrodes 120, and a plurality of external electrodes 130.

The plurality of internal electrodes 120 are disposed on the inner wall surface 111 of the tubular body 110. The plurality of internal electrodes 120 include a plurality of (four in the drawing) deflection electrodes 121A to 121D and a plurality of (four in the drawing) ground electrodes 122A to 122D.

The plurality of deflection electrodes 121A to 121D are disposed in this order at intervals of 90° on the inner wall surface 111. That is, the deflection electrode 121A and the deflection electrode 121C are positioned to face each other across the center of the tubular body 110, and the deflection electrode 121B and the deflection electrode 121D are positioned to face each other across the center of the tubular body 110.

The ground electrode 122A is provided between the deflection electrode 121A and the deflection electrode 121B, and the ground electrode 122B is provided between the deflection electrode 121B and the deflection electrode 121C. Further, the ground electrode 122C is provided between the deflection electrode 121C and the deflection electrode 121D, and the ground electrode 122D is provided between the deflection electrode 121D and the deflection electrode 121A.

The plurality of external electrodes 130 are disposed on the outer wall surface 112 of the tubular body 110. The outer wall surface 112 is an example of a surface other than the inner wall surface 111. The plurality of external electrodes 130 include a plurality of (four in the drawing) control electrodes 131A to 131D and an external ground electrode 132.

A part of the control electrode 131A is disposed adjacent to the deflection electrode 121A in the radial direction, and a part of the control electrode 131B is disposed adjacent to the deflection electrode 121B in the radial direction.

A part of the control electrode 131C is disposed adjacent to the deflection electrode 121C in the radial direction, and a part of the control electrode 131D is disposed adjacent to the deflection electrode 121D in the radial direction. A part of the external ground electrode 132 is disposed adjacent to the ground electrode 122B in the radial direction.

FIG. 11 is a cross-sectional view taken along the line D-D in a direction of arrows in FIG. 10. FIG. 12 is a horizontal cross-sectional view illustrating the configuration of the electrostatic deflector 100 according to the embodiment. Note that, FIG. 12 is a horizontal cross-sectional view of the first region R1 illustrated in FIG. 11.

As illustrated in FIGs. 11 and 12, in the electrostatic deflector 100 according to the embodiment, the deflection electrode 121A of the internal electrode 120 and the control electrode 131A of the external electrode 130 are electrically connected to each other via the connection conductor 140 in the first region R1.

The connection conductor 140 is formed by firing the connecting portion 21d (see FIG. 7) of the second compact 30 in the firing step.

As illustrated in FIG. 12, in the electrostatic deflector 100 according to the embodiment, the deflection electrode 121B and the control electrode 131B are electrically connected to each other via the connection conductor 140, the deflection electrode 121C and the control electrode 131C are electrically connected to each other via the connection conductor 140, and the deflection electrode 121D and the control electrode 131D are electrically connected to each other via the connection conductor 140.

In the electrostatic deflector 100 according to the embodiment, by applying a predetermined voltage to the control electrodes 131A to 131D, the predetermined voltage is applied to the deflection electrodes 121A to 121D via the connection conductor 140, thereby generating a magnetic field in an internal space S. Accordingly, in the electrostatic deflector 100, the irradiation direction of the electron beam passing through the internal space S can be controlled.

Here, in the embodiment, the annular first compacts 10 on which the wiring layers 21 are formed are layered to form the second compact 30, and the second compact 30 is fired to form the tubular body 110 of the electrostatic deflector 100.

Accordingly, the internal electrode 120 of the inner wall surface 111 and the external electrode 130 of the outer wall surface 112 can be electrically connected to each other without providing a separate pin. Thus, according to the embodiment, the number of components of the electrostatic deflector 100 can be reduced.

In the embodiment, a step of brazing a pin is not required, thereby reducing the number of steps when manufacturing the electrostatic deflector 100. Thus, according to the embodiment, the manufacturing cost of the electrostatic deflector 100 can be reduced.

In the embodiment, the flatness of the internal electrode 120 can be improved. The reason will be described below.

When the inner wall surface 111 is cut and flattened after brazing the pin and the internal electrode 120 is formed on the flattened surface, since the pin and the brazing material have higher ductility than the ceramic, the ceramic is ground more in the grinding step and the pin protrudes from the inner wall surface 111 to some extent after the grinding.

Therefore, when the internal electrode 120 is formed after grinding, the internal electrode 120 is also formed on the protruding pin, which may adversely affect the flatness of the internal electrode 120.

On the other hand, in the embodiment, when the inner wall surface 111 of the tubular body 110 is cut and flattened, since the thickness of the connection conductor 140 is extremely thin, the connection conductor 140 is cut together with the ceramic.

Therefore, according to the embodiment, the connection conductor 140 hardly protrudes from the inner wall surface 111 after grinding, thereby improving the flatness of the internal electrode 120.

In the embodiment, by layering the annular first compacts 10 on which the through wiring layers 22 are formed to form the second compact 30, the via conductor 142 extending along the layering direction can be formed in the inner portion of the tubular body 110.

Accordingly, adjacent connection conductors 140 can be electrically connected to each other via the via conductor 142. Therefore, according to the embodiment, more conductive paths connecting the internal electrode 120 and the external electrode 130 can be formed.

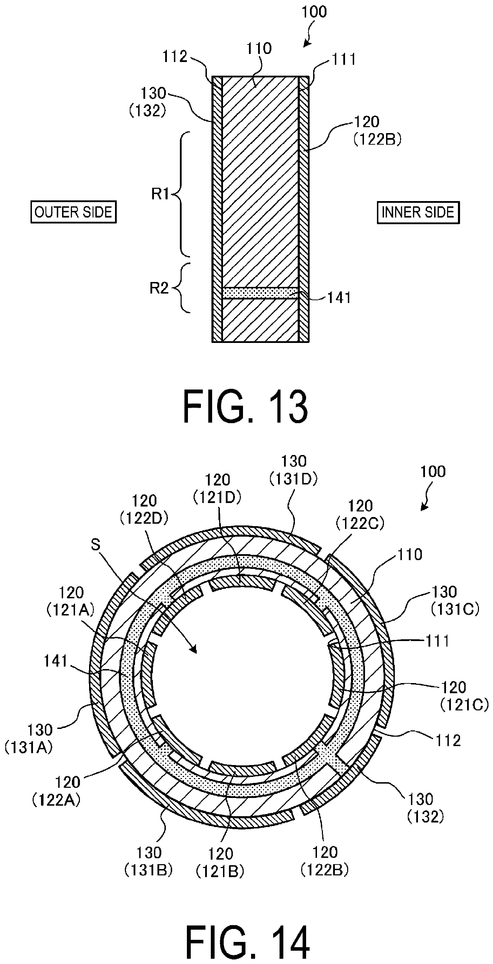

FIG. 13 is a cross-sectional view taken along the line E-E in a direction of arrows in FIG. 10. FIG. 14 is a horizontal cross-sectional view illustrating the configuration of the electrostatic deflector 100 according to the embodiment. Note that, FIG. 14 is a horizontal cross-sectional view of the second region R2 illustrated in FIG. 13.

As illustrated in FIGs. 13 and 14, in the electrostatic deflector 100 according to the embodiment, the ground electrodes 122A to 122D of the internal electrode 120 and the external ground electrode 132 of the external electrode 130 are electrically connected to each other via the connection conductor 141 in the second region R2.

The connection conductor 141 is formed by firing the annular portion 21a, the inner peripheral connecting portion 21b, and the outer peripheral connecting portion 21c (see FIG. 9) of the second compact 30 in the firing step.

In the electrostatic deflector 100 according to the embodiment, the ground electrodes 122A to 122D are set to the ground potential or the 0 potential by setting the external ground electrode 132 to the ground potential or the 0 potential, thereby suppressing the tubular body 110 from being charged by electrons entering the tubular body 110 while deviating from the trajectory.

Accordingly, in the electrostatic deflector 100, the potential of the deflection electrodes 121A to 121D can be suppressed from fluctuating due to an unexpected potential generated on the inner wall surface 111 caused by the accumulation and charging of the electrons deviated from the trajectory in the exposed ceramic. Therefore, according to the embodiment, the irradiation direction of the electron beam passing through the internal space S can be accurately controlled.

Here, in the embodiment, the annular first compacts 10 on which the wiring layers 21 are formed are layered to form the second compact 30, and the second compact 30 is fired to form the tubular body 110 of the electrostatic deflector 100. Therefore, the connection conductor 141 having a complicated shape can be formed inside the tubular body 110.

For example, in the embodiment, the external electrodes 130 connected to the plurality of ground electrodes 122A to 122D can be integrated into one external ground electrode 132. Thus, according to the embodiment, the number of components of the electrostatic deflector 100 can be reduced.

Note that, in the present disclosure, adjacent internal electrodes 120 may be separated from each other by 100 (µm) or more, and adjacent external electrodes 130 may be separated from each other by 100 (µm) or more. Accordingly, a short between adjacent electrodes can be suppressed.

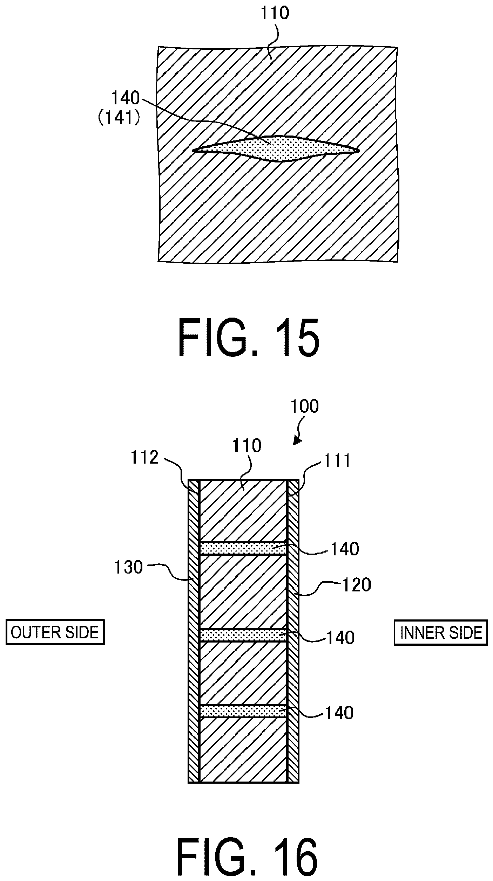

FIG. 15 is an enlarged cross-sectional view illustrating the configuration of the connection conductor 140, 141 according to the embodiment. As illustrated in FIG. 15, the connection conductor 140, 141 according to the embodiment has a shape in which an end portion is crushed in a cross-sectional view. Such a shape is formed by compressing the plurality of layered first compacts 10 to crush the end portions of the wiring layers 21 in the second molding step described above.

By shaping the end portion of the connection conductor 140, 141 as illustrated in FIG. 15, the thermal stress can be made difficult to concentrate on the end portion of the connection conductor 140, 141. Thus, according to the embodiment, the electrostatic deflector 100 can have improved reliability.

### First Variation

Various variations of the embodiment will be described with reference to FIGs. 16 to 22. FIG. 16 is a vertical cross-sectional view illustrating a configuration of the electrostatic deflector 100 according to a first variation of the embodiment.

As illustrated in FIG. 16, in the first variation, the internal electrode 120 and the external electrode 130 as a pair are electrically connected to each other by a plurality of connection conductors 140. Accordingly, more conductive paths connecting the internal electrode 120 and the external electrode 130 can be formed.

Therefore, according to the first variation, for example, when the internal electrode 120 is a ground electrode, electrons that have deviated from their trajectories can be quickly released.

### Second Variation

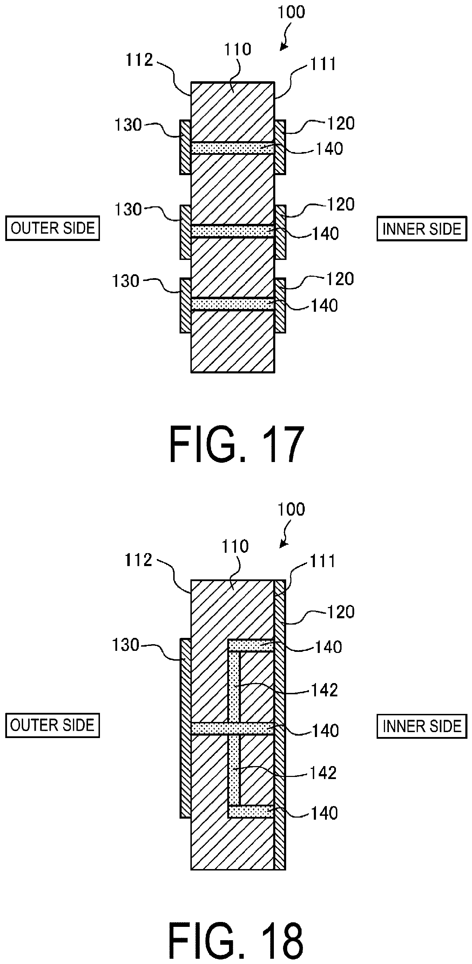

FIG. 17 is a vertical cross-sectional view illustrating the configuration of the electrostatic deflector 100 according to a second variation of the embodiment. As illustrated in FIG. 17, in the second variation, a plurality of (three in the drawing) internal electrodes 120 are disposed side by side on the inner wall surface 111 of the tubular body 110 along the layering direction of the tubular body 110 (i.e., feed direction of electrons).

All of the internal electrodes 120 disposed in the layering direction are provided with the individual separate connection conductors 140 and the individual external electrodes 130, respectively.

Accordingly, for example, when the internal electrode 120 is a deflection electrode, individual voltages can be applied to the internal space S (see FIG. 10) of the tubular body 110 along the feed direction of the electrons. Therefore, according to the second variation, the irradiation direction of the electron beam passing through the internal space S can be accurately controlled.

### Third Variation

FIG. 18 is a vertical cross-sectional view illustrating the configuration of the electrostatic deflector 100 according to a third variation of the embodiment. As described above, in the present disclosure, the annular first compacts 10 on which the through wiring layers 22 are formed are layered to form the second compact 30, and the second compact 30 is fired to form the tubular body 110 of the electrostatic deflector 100. Therefore, the via conductor 142 extending along the layering direction can be formed inside the tubular body 110.

Accordingly, as illustrated in FIG. 18, the plurality of connection conductors 140 connected to one internal electrode 120 can be collectively connected to the external electrode 130 in one place by using the via conductor 142.

Therefore, according to the third variation, the area of the external electrode 130 can be reduced, thereby simplifying the configuration of the electrostatic deflector 100.

### Fourth Variation

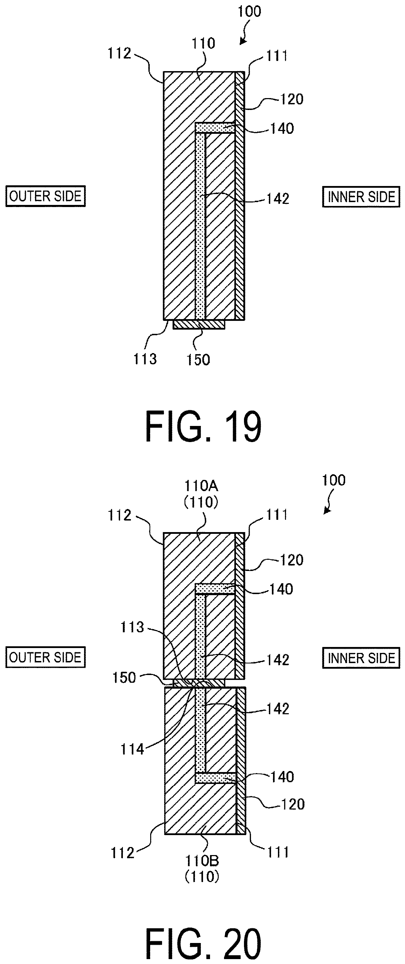

FIG. 19 is a vertical cross-sectional view illustrating the configuration of the electrostatic deflector 100 according to a fourth variation of the embodiment. As illustrated in FIG. 19, in the fourth variation, an external electrode 150 is disposed on a bottom surface 113 of the tubular body 110. The bottom surface 113 is another example of a surface other than the inner wall surface 111.

The internal electrode 120 and the external electrode 150 are electrically connected to each other through the connection conductor 140 and the via conductor 142.

As described above, in the fourth variation, by using the connection conductor 140 and the via conductor 142, wiring can be routed on any surface (here, the bottom surface 113) of the tubular body 110. Thus, according to the fourth variation, the degree of freedom in designing the electrostatic deflector 100 can be enhanced.

### Fifth Variation

FIG. 20 is a vertical cross-sectional view illustrating the configuration of the electrostatic deflector 100 according to a fifth variation of the embodiment. As illustrated in FIG. 20, in the fifth variation, two tubular bodies 110A and 110B are connected to each other to configure one electrostatic deflector 100.

Specifically, in one tubular body 110A, the connection conductor 140 extends outward from the internal electrode 120 of the tubular body 110A, and the connection conductor 140 is electrically connected to the via conductor 142 extending toward the bottom surface 113.

In the other tubular body 110B, the connection conductor 140 extends outward from the internal electrode 120 of the tubular body 110B, and the connection conductor 140 is electrically connected to the via conductor 142 extending toward an upper surface 114. The upper surface 114 is another example of a surface other than the inner wall surface 111.

The bottom surface 113 of the tubular body 110A and the upper surface 114 of the tubular body 110B are bonded to each other via the same external electrode 150, whereby the via conductor 142 of the tubular body 110A and the via conductor 142 of the tubular body 110B are electrically connected to each other.

Accordingly, in the fifth variation, the two tubular bodies 110A and 110B can share the external electrode 150. Thus, according to the fifth variation, the configuration of the electrostatic deflector 100 can be simplified.

Note that, techniques of connecting the tubular body 110A and the tubular body 110B can include glass bonding, fixing by an O-ring, or the like.

### Sixth Variation

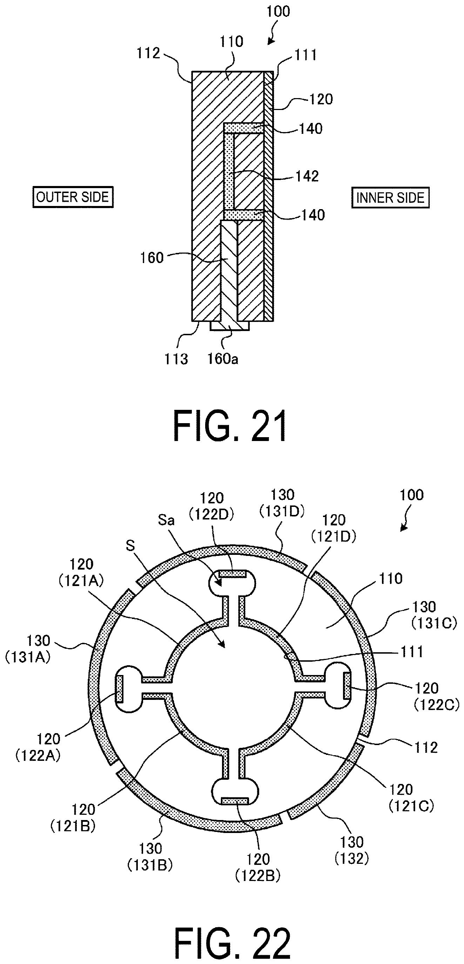

FIG. 21 is a vertical cross-sectional view illustrating the configuration of the electrostatic deflector 100 according to a sixth variation of the embodiment. As illustrated in FIG. 21, in the sixth variation, a metal pin 160 is inserted from the bottom surface 113 of the tubular body 110 along the layering direction, and is electrically connected to the connection conductor 140 inside the tubular body 110.

Accordingly, in the sixth variation, the pin 160 can be substituted for the via conductor 142. In the sixth variation, a base end portion 160a of the wide pin 160 can be substituted for the external electrode 150. Thus, according to the sixth variation, the configuration of the electrostatic deflector 100 can be simplified.

In the sixth variation, the pin 160 is not limited to being electrically connected to the connection conductor 140, and may be electrically connected to the via conductor 142. In the sixth variation, the pin 160 may be bonded to the connection conductor 140 or the via conductor 142 using an electrically conductive bonding material.

Such electrically conductive bonding materials can include, for example, a bonding material obtained by adding a conductive filler to an inorganic (for example, glass) paste or an organic (for example, epoxy resin, cyanate resin, acrylic resin, maleimide resin, or the like) paste.

The hole through which the pin 160 is inserted may be formed by layering the first compacts 10 having such a hole, or may be formed by grinding the tubular body 110 after the firing step.

### Seventh Variation

FIG. 22 is a top view illustrating the configuration of the electrostatic deflector 100 according to a seventh variation of the embodiment. As illustrated in FIG. 22, in the seventh variation, a plurality of (four in the drawing) space portions Sa are formed outside the internal space S of the tubular body 110. The space portion Sa protrudes from the cylindrical internal space S toward the outer wall surface 112 of the tubular body 110. The four space portions Sa are disposed at intervals of 90 degrees.

In the seventh variation, the deflection electrodes 121A to 121D are disposed to be in contact with the internal space S, and the ground electrodes 122A to 122D are disposed to be in contact with the space portion Sa.

Note that, in the variation 7, the deflection electrodes 121A to 121D are also disposed on the inner walls of the passages connecting the internal space S and the space portion Sa. The side portion of the space portion Sa has an R shape, and the radius of curvature of the R shape is, for example, 0.25 to 0.5 (mm).

In the variation 7, the ground electrodes 122A to 122D disposed to be in contact with the space portion Sa may be disposed only at a site on the back side of the space portion Sa (that is, a site with which electrons may collide).

With such a configuration, in the seventh variation, the region of the deflection electrodes 121A to 121D can be increased, and thus the electron beam can be easily controlled. Further, in the seventh variation, the electrons entering the space portion Sa are less likely to return to the internal space S, and thus the reliability of the electrostatic deflector 100 can be improved.

In the present disclosure, the second compact 30 is molded by layering the annular first compacts 10 and the tubular body 110 of the electrostatic deflector 100 is formed by firing the second compact 30. Therefore, even the electrostatic deflector 100 having a complicated shape as illustrated in FIG. 22 can be easily manufactured.

Although an embodiment of the present disclosure has been described above, the present disclosure is not limited to the embodiment described above, and various changes can be made without departing from the spirit of the present disclosure. For example, although an example in which four deflection electrodes are provided on the inner wall surface 111 of the tubular body 110 has been described in the present disclosure, the number of deflection electrodes provided on the tubular body 110 is not limited to four.

Additional effects and other aspects can be easily derived by a person skilled in the art. Thus, a wide variety of aspects of the present invention are not limited to the specific details and representative embodiments represented and described above. Accordingly, various changes are possible without departing from the spirit or scope of the general inventive concepts defined by the appended claims and their equivalents.

### REFERENCE SIGNS

10 to 15 First compact
21 Wiring layer
22 Through wiring layer
30 Second compact
100 Electrostatic deflector
110 Tubular body
111 Inner wall surface
112 Outer wall surface (an example of a surface other than the inner wall surface)
120 Internal electrode
121A to 121D Deflection electrode
122A to 122D Ground electrode
130 External electrode
131A to 131D Control electrode
132 External ground electrode
140, 141 Connection conductor
142 Via conductor
S Internal space

## Claims

1. A manufacturing method for an electrostatic deflector, the manufacturing method comprising:
obtaining a plurality of first compacts having a sheet-like shape by molding a raw material containing a ceramic into each desired shape;
obtaining a second compact by layering the plurality of first compacts;
obtaining a tubular body by firing the second compact; and
forming an internal electrode and an external electrode on an inner wall surface of the tubular body and on a surface other than the inner wall surface, wherein
in the obtaining the plurality of first compacts, a wiring layer serving as a connection conductor that electrically connects the internal electrode and the external electrode is formed on a surface of the first compact that is predetermined.

2. The manufacturing method for an electrostatic deflector according to claim 1, wherein
the wiring layer is formed by printing a metal paste.

3. The manufacturing method for an electrostatic deflector according to claim 1 or 2, wherein
the wiring layer is formed on a surface of the plurality of first compacts that are predetermined.

4. The manufacturing method for an electrostatic deflector according to any one of claims 1 to 3, wherein,
in the obtaining the second compact, the plurality of first compacts layered are compressed to crush an end portion of the wiring layer.

5. The manufacturing method for an electrostatic deflector according to any one of claims 1 to 4, wherein
in the obtaining the plurality of first compacts, another wiring layer passing through the first compact that is predetermined is formed in the first compact.

6. The manufacturing method for an electrostatic deflector according to claim 5, wherein
the another wiring layer is formed to be connected to the wiring layer.

7. An electrostatic deflector comprising:
a tubular body at least a part of which is made of a ceramic;
a plurality of ground electrodes located on an inner wall surface of the tubular body;
one external ground electrode located on a surface of the tubular body other than the inner wall surface; and
a connection conductor located inside the tubular body and electrically connecting the plurality of ground electrodes and the one external ground electrode.
